# EUROPÄISCHE PATENTANMELDUNG

(11) **EP 4 752 122 A1**
(43) Veröffentlichungstag der Anmeldung: **03.06.2026**
(21) Anmeldenummer: 24216356.6
(22) Anmeldetag: 29.11.2024
(51) Int. Cl.: C04B 37/02

(54) **METALL-KERAMIK-SUBSTRAT UND ELEKTRONISCHES BAUTEIL UMFASSEND EIN METALL-KERAMIK-SUBSTRAT**

(71) Anmelder: Heraeus Electronics GmbH & Co. KG, 63450 Hanau (DE)
(72) Erfinder: Niewolak, Leszek, 63450 Hanau (DE); Denadic, Ruzica, 63450 Hanau (DE); Schlüter, Bastian, 63450 Hanau (DE); Wacker, Richard, 63450 Hanau (DE)
(74) Vertreter: Heraeus IP

(57) **Zusammenfassung**

Die Erfindung betrifft ein Metall-Keramik-Substrat und ein elektronisches Bauteil umfassend ein Metall-Keramik-Substrat. Das Metall-Keramik-Substrat enthält (i) einen Keramikkörper, (ii) eine Metallschicht, die mit dem Keramikkörper flächig verbunden ist, wobei die Metallschicht wenigstens eine Aussparung aufweist und eine Oberfläche des Keramikkörpers durch die Aussparung freigelegt ist, wobei die durch die Aussparung freigelegten Oberfläche des Keramikkörpers einen Gehalt von 0,5 - 15 Gewichtsprozent eines Aktivmetall aufweist.

## Beschreibung

Die vorliegende Erfindung betrifft ein Metall-Keramik-Substrat und ein elektronisches Bauteil umfassend ein Metall-Keramik-Substrat.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund erhitzt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

In einem alternativen Verfahren können Metallfolien bei Temperaturen von etwa 650 bis 1000°C mit Keramikkörpern verbunden werden, wobei ein spezielles Aktivlot verwendet wird, das ein Metall mit einem Schmelzpunkt von wenigstens 700°C (üblicherweise Silber) und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Metall mit einem Schmelzpunkt von wenigstens 700°C zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Alternativ dazu können auch silberfreie Aktivlote zur Verbindung von Metallfolien mit Keramikkörpern zum Einsatz kommen. Diese Aktivlote basieren zum Beispiel auf hochschmelzenden Metallen (insbesondere Kupfer), niedrigschmelzenden Metallen (wie Bismut, Indium oder Zinn) und Aktivmetallen (wie Titan). Eine solche Technik wird zum Beispiel in der DE 102017114893 A1 vorgeschlagen. Diese Technik führt im Grunde zu einer neuen, eigenständigen Verbindungsklasse, da die Basis der verwendeten Lote durch ein anderes Metall (Kupfer statt Silber) gebildet wird, was zu geänderten Materialeigenschaften führt und eine Anpassung im Hinblick auf die übrigen Lotbestandteile und modifizierte Fügebedingungen zur Folge hat.

Beim Aufbau solcher aktivgelöteten Metall-Keramik-Substrate wird die Metallfolie üblicherweise zunächst vollflächig über das Aktivlot mit dem Keramikmaterial verbunden. In einem Folgeschritt wird das Metall-Keramik-Substrat strukturiert, um zum Beispiel Kontaktbereiche für Halbleiterbauelemente (wie Chips) zu erzeugen. Zur Strukturierung wird das Metall-Keramik-Substrat in der Regel zunächst mit einer ersten Ätzlösung behandelt, mit der die Metallfolie bereichsweise entfernt wird. Anschließend erfolgt üblicherweise die Behandlung mit einer zweiten Ätzlösung, um auch die zurückbleibende aktivmetallhaltige Reaktionsschicht vollständig abzutragen und so die einzelnen Kontaktbereiche voneinander elektrisch zu isolieren.

Die so hergestellten Metall-Keramik-Substrate sind als Teil von elektronischen Bauteilen im Betrieb üblicherweise hohen Spannungen ausgesetzt. Mit hohen Spannungen steigt die Gefahr, dass die Isolierung zwischen den Kontaktbereichen der elektrischen Belastung nicht standhält und es zu einer Teilentladung kommt. Um dieser vorzubeugen, muss daher sichergestellt sein, dass die Kontaktbereiche ausreichend voneinander isoliert sind.

Wünschenswert wäre es daher, die Teilentladungsfestigkeit von Metall-Keramik-Substraten weiter zu erhöhen.

Eine Aufgabe der vorliegenden Erfindung besteht daher darin, ein Metall-Keramik-Substrat zur Verfügung zu stellen, das eine erhöhte Teilentladungsfestigkeit aufweist.

Diese Aufgabe wird gelöst durch das Metall-Keramik-Substrat von Anspruch 1. Die Erfindung stellt daher ein Metall-Keramik-Substrat bereit enthaltend
(i) einen Keramikkörper,
(ii) eine Metallschicht, die mit dem Keramikkörper flächig verbunden ist, wobei die Metallschicht wenigstens eine Aussparung aufweist und eine Oberfläche des Keramikkörpers durch die Aussparung freigelegt ist,
wobei die durch die Aussparung freigelegte Oberfläche des Keramikkörpers einen Gehalt von 0,5 - 15 Gewichtsprozent eines Aktivmetall aufweist.

Ferner betrifft die Erfindung ein elektronisches Bauteil umfassend ein solches Metall-Keramik-Substrat.

Außerdem betrifft die Erfindung ein Verfahren zur Herstellung eines Metall-Keramik-Substrats.

Das erfindungsgemäße Metall-Keramik-Substrat umfasst einen Keramikkörper.

Der Keramikkörper ist vorzugsweise ein Körper, der aus Keramik gebildet ist. Der Körper kann eine beliebige Geometrie einnehmen, ist aber vorzugsweise als Quader ausgestaltet. Der Keramikkörper weist Begrenzungsflächen auf, im Falle eines Quaders sechs Begrenzungsflächen. Der Keramikkörper weist vorzugsweise eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die mit der Metallschicht flächig verbunden ist. Als Hauptbegrenzungsfläche wird besonders bevorzugt die Begrenzungsfläche (ganz besonders bevorzugt die Begrenzungsfläche mit dem größten Flächeninhalt) bezeichnet, die mit der Metallschicht, die wenigstens eine Aussparung aufweist, flächig verbunden ist. Die Hauptbegrenzungsfläche liegt vorzugsweise in der Haupterstreckungsebene des Keramikkörpers oder verläuft parallel zu dieser. Demnach wird unter Haupterstreckungsebene des Keramikkörpers vorzugsweise eine Ebene verstanden, die parallel zur Hauptbegrenzungsfläche des Keramikkörpers verläuft oder diese umschließt.

Die Keramik des Keramikkörpers ist vorzugsweise eine isolierende Keramik. Gemäß einer bevorzugten Ausführungsform ist die Keramik aus der Gruppe ausgewählt, die aus Oxidkeramiken, Nitridkeramiken und Carbidkeramiken besteht. Gemäß einer weiteren bevorzugten Ausführungsform ist die Keramik aus der Gruppe ausgewählt, die aus Metalloxidkeramiken, Siliziumoxidkeramiken, Metallnitridkeramiken, Siliziumnitridkeramiken, Bornitridkeramiken und Borcarbidkeramiken besteht. Gemäß einer besonders bevorzugten Ausführungsform ist die Keramik aus der Gruppe ausgewählt, die aus Aluminiumnitridkeramiken, Siliziumnitridkeramiken und Aluminiumoxidkeramiken (wie zum Beispiel ZTA ("Zirconia Toughened Alumina") -Keramiken) besteht. Gemäß einer weiteren ganz besonders bevorzugten Ausführungsform besteht der Keramikkörper aus (1) wenigstens einem Element, das aus der Gruppe ausgewählt ist, die aus Silizium und Aluminium besteht, (2) wenigstens einem Element, das aus der Gruppe ausgewählt ist, die aus Sauerstoff und Stickstoff besteht, optional (3) wenigstens einem Element, das aus der Gruppe ausgewählt ist, die aus (3a) Metallen der seltenen Erden, (3b) Metallen der zweiten Hauptgruppe des Periodensystems der Elemente, (3c) Zirkonium, (3d) Kupfer, (3e) Molybdän und (3f) Silizium besteht, und optional (4) unvermeidlichen Verunreinigungen.

Der Keramikkörper weist vorzugsweise eine Dicke im Bereich von 0,05 - 10 mm, mehr bevorzugt eine Dicke im Bereich von 0,1 - 5 mm und besonders bevorzugt eine Dicke im Bereich von 0,15 - 3 mm auf.

Das erfindungsgemäße Metall-Keramik-Substrat umfasst eine Metallschicht, die flächig mit dem Keramikkörper verbunden ist, wobei die Metallschicht wenigstens eine Aussparung aufweist und eine Oberfläche des Keramikkörpers durch die Aussparung freigelegt ist.

Die Metallschicht weist vorzugsweise Begrenzungsflächen auf. Die Metallschicht weist vorzugsweise eine Hauptbegrenzungsfläche auf. Als Hauptbegrenzungsfläche wird hierin vorzugsweise die Begrenzungsfläche (ganz besonders bevorzugt die Begrenzungsfläche mit dem größten Flächeninhalt) bezeichnet, die dem Keramikkörper abgewandt ist. Die Hauptbegrenzungsfläche liegt vorzugsweise in der Haupterstreckungsebene der Metallschicht oder verläuft parallel zu dieser. Demnach wird unter Haupterstreckungsebene der Metallschicht vorzugsweise eine Ebene verstanden, die parallel zur Hauptbegrenzungsfläche der Metallschicht verläuft oder diese umschließt. Die Hauptbegrenzungsfläche der Metallschicht verläuft vorzugsweise parallel zur Hauptbegrenzungsfläche des Keramikkörpers und ist von dieser besonders bevorzugt beabstandet.

Die Metallschicht umfasst vorzugsweise wenigstens ein Metall, das aus der Gruppe ausgewählt ist, die aus Kupfer und Aluminium besteht. Gemäß einer ganz besonders bevorzugten Ausführungsform umfasst die Metallschicht Kupfer. Gemäß einer weiteren bevorzugten Ausführungsform umfasst die Metallschicht eine Reaktionsschicht. Die Reaktionsschicht umfasst vorzugsweise ein Aktivmetall. Vorzugsweise steht die Reaktionsschicht mit dem Keramikkörper in Kontakt. Ferner steht die Reaktionsschicht vorzugsweise mit der übrigen Metallschicht in Kontakt. Daher befindet sich die Reaktionsschicht vorzugsweise zwischen dem Keramikkörper und der übrigen Metallschicht. Gemäß einer bevorzugten Ausführungsform weist die Reaktionsschicht einen höheren Gehalt an Aktivmetall auf als die übrige Metallschicht. Gemäß einer weiteren bevorzugten Ausführungsform beträgt der Anteil an Kupfer wenigstens 60 Gewichtsprozent, mehr bevorzugt wenigstens 65 Gewichtsprozent, noch mehr bevorzugt wenigstens 70 Gewichtsprozent und besonders bevorzugt wenigstens 75 Gewichtsprozent, bezogen auf das Gesamtgewicht der Metallschicht.

Die Metallschicht ist mit dem Keramikkörper vorzugsweise flächig verbunden. Vorzugsweise ist die Metallschicht mit dem Keramikkörper stoffschlüssig verbunden. Gemäß einer bevorzugten Ausführungsform ist die Metallschicht mit dem Keramikkörper über ein Aktivlotverfahren verbunden. Bei dem Aktivlotverfahren kann es sich zum Beispiel um ein AMB (Active Metal Brazing)-Verfahren handeln. Beim AMB-Verfahren wird die Metallschicht mit dem Keramikkörper vorzugsweise stoffschlüssig unter Verwendung eines Aktivlotes verbunden. Gemäß einer bevorzugten Ausführungsform umfasst das Aktivlot ein Metall M1 mit einem Schmelzpunkt von wenigstens 700°C. Das Metall M1 ist vorzugsweise Kupfer. Gemäß einer weiter bevorzugten Ausführungsform umfasst das Aktivtlot ein Metall M2 mit einem Schmelzpunkt von weniger als 700°C auf. Das Metall M2 ist vorzugsweise Zinn. Gemäß einer noch weiter bevorzugten Ausführungsform umfasst das Aktivlot ein Metall M3, das aus der Gruppe der Aktivmetalle ausgewählt ist. Das Metall M3 ist vorzugsweise aus der Gruppe ausgewählt, die aus Hafnium, Titan, Zirkonium, Niob, Tantal, Vanadium und Cer besteht. Besonders bevorzugt ist das Metall M3 Titan. Gemäß einer noch weiter bevorzugten Ausführungsform umfasst das Aktivlot ein Metall M4, das aus der Gruppe ausgewählt ist, die aus Bismut, Gallium, Zink, Indium, Germanium, Aluminium und Magnesium besteht. Gemäß einer bevorzugten Ausführungsform weist das Aktivlot einen Gehalt an Silber von weniger als 1,0 Gewichtsprozent basierend auf dem Feststoffgehalt des Aktivlotes auf. Gemäß einer alternativen Ausführungsform weist das Aktivlot einen Gehalt an Silber von wenigstens 50 Gewichtsprozent basierend auf dem Feststoffgehalt des Aktivlotes auf. Beim Aktivlotverfahren bildet sich vorzugsweise als Teil der Metallschicht eine Reaktionsschicht aus, über die die Metallschicht mit dem Keramikkörper stoffschlüssig verbunden ist.

Die Metallschicht ist mit dem Keramikkörper vorzugsweise flächig verbunden. Dementsprechend ist die Metallschicht flächig vorzugsweise mit der Hauptbegrenzungsfläche des Keramikkörpers verbunden. Die Metallschicht ist vorzugsweise nicht mit der gesamten Hauptbegrenzungsfläche des Keramikkörpers verbunden. Insbesondere kann es vorgesehen sein, dass die Hauptbegrenzungsfläche des Keramikkörpers größer ist als die Fläche der mit dem Keramikkörper verbundenen Metallschicht. In diesen Fällen steht die Hauptbegrenzungsfläche des Keramikkörpers über.

Die Metallschicht weist vorzugsweise eine Dicke im Bereich von 0,01 - 10 mm, besonders bevorzugt eine Dicke im Bereich von 0,03 - 5 mm und ganz besonders bevorzugt eine Dicke im Bereich von 0,05 - 3 mm auf.

Die Metallschicht weist wenigstens eine Aussparung auf, wobei eine Oberfläche des Keramikkörpers durch die Aussparung freigelegt ist. Durch die wenigstens eine Aussparung werden vorzugsweise voneinander getrennte Bereiche der Metallschicht elektrisch voneinander isoliert. Die Metallschicht, die wenigstens eine Aussparung aufweist, kann auch als strukturierte Metallschicht bezeichnet werden. Auf der strukturierten Metallschicht können Halbleiterbauelemente angebracht werden. Die wenigstens eine Aussparung wird vorzugsweise durch Behandlung der Metallschicht mit wenigstens einer Ätzlösung und/oder mit Strahlungsenergie erzeugt.

Unter Aussparung wird vorzugsweise ein Bereich der Metallschicht verstanden, der durch Abtragung von Material der Metallschicht erhalten wird. Vorzugsweise ist eine Aussparung ein von Material der Metallschicht befreiter Bereich, der sich zwischen (besonders bevorzugt in der Haupterstreckungsebene der Metallschicht) benachbarten Bereichen der Metallschicht befindet. Daher liegt eine Aussparung vorzugsweise zwischen zwei benachbarten Bereichen einer Metallschicht vor.

Die durch die Aussparung freigelegte Oberfläche des Keramikkörpers weist vorzugsweise Material des Keramikkörpers auf. Die durch die Aussparung freigelegte Oberfläche des Keramikkörpers weist Aktivmetall auf. Das Aktivmetall stammt vorzugsweise aus einer beim Aktivlotverfahren erzeugten Reaktionsschicht. Das Aktivmetall liegt vorzugsweise als Reaktionsprodukt mit Elementen des Keramikmaterials vor. Gemäß einer bevorzugten Ausführungsform liegt das Aktivmetall als Aktivmetallverbindung vor. Die Aktivmetallverbindung ist vorzugsweise aus der Gruppe ausgewählt, die aus Aktivmetallnitriden, Aktivmetallsiliziden und Aktivmetallaluminden besteht. Besonders bevorzugt handelt es sich bei der Aktivmetallverbindung um Titannitrid, Titansilizid oder Titanaluminid. Das Aktivmetall ist vorzugsweise aus der Gruppe ausgewählt, die aus Hafnium, Titan, Zirkonium, Niob, Vanadium, Tantal, Cer und Mischungen davon besteht. Gemäß einer besonders bevorzugten Ausführungsform ist das Aktivmetall Titan.

Erfindungsgemäß weist die durch die Aussparung freigelegte Oberfläche des Keramikkörpers einen Gehalt von 0,5 - 15 Gewichtsprozent eines Aktivmetall auf. Gemäß einer bevorzugten Ausführungsform weist die durch die Aussparung freigelegte Oberfläche des Keramikkörpers einen Gehalt von 0,6 - 14 Gewichtsprozent auf. Der Gehalt von Aktivmetall an der durch die Aussparung freigelegten Oberfläche des Keramikkörpers wird vorzugsweise mittels Rasterelektronenmikroskopie - energiedispersiver Röntgenspektroskopie (SEM-EDX) bestimmt.

Überraschenderweise wurde festgestellt, dass die Teilentladungsfestigkeit eines Metall-Keramik-Substrats deutlich erhöht ist, wenn die durch die Aussparung freigelegte Oberfläche des Keramikkörpers einen Gehalt von 0,5 - 15 Gewichtsprozent eines Aktivmetall aufweist.

Gemäß einer weiteren bevorzugten Ausführungsform weist die durch die wenigstens eine Aussparung freigelegte Oberfläche des Keramikkörpers Aktivmetallinseln auf. Unter Aktivmetallinsel werden vorzugsweise in einer mittels Rasterelektronenmikroskopie - energiedispersiver Röntgenspektroskopie (SEM-EDX) erhaltenen Aufnahme (vorzugsweise wie unter Testmethoden beschrieben) abgrenzbare Bereiche mit einer Akkumulation von Aktivmetall verstanden.

Gemäß noch einer weiteren bevorzugten Ausführungsform weisen die Aktivmetallinseln eine durchschnittliche Fläche im Bereich von 5 - 65 µm² auf. Die Aktivmetallinseln weisen besonders bevorzugt eine durchschnittliche Fläche im Bereich von 10 - 65 µm² und ganz besonders bevorzugt eine durchschnittliche Fläche im Bereich von 10 - 60 µm² auf.

Gemäß noch einer weiteren bevorzugten Ausführungsform sind die Aktivmetallinseln durchschnittlich wenigstens 2 µm voneinander beabstandet.

Die Aktivmetallinseln sind durchschnittlich vorzugsweise wenigstens 2 µm, besonders bevorzugt wenigstens 3 µm und ganz besonders bevorzugt wenigstens 4 µm voneinander beabstandet. Die Aktivmetallinseln sind durchschnittlich vorzugsweise weniger als 20 µm, besonders bevorzugt weniger als 18 µm und ganz besonders bevorzugt weniger als 15 µm voneinander beabstandet. Gemäß einer bevorzugten Ausführungsform sind die Aktivmetallinseln durchschnittlich 2 - 20 µm, besonders bevorzugt 3 - 18 µm und ganz besonders bevorzugt 4 - 15 µm voneinander beabstandet.

Überraschenderweise hat sich gezeigt, dass durch die Erzeugung von Aktivmetallinseln, die
(A) eine durchschnittliche Fläche im Bereich von 5 - 65 µm² aufweisen, und
(B) durchschnittlich wenigstens 2 µm voneinander beabstandet sind,
die Teilentladungsfestigkeit weiter erhöht werden kann.

Gemäß einer bevorzugten Ausführungsform umfasst das Metall-Keramik-Substrat eine weitere (zweite) Metallschicht, die flächig mit dem Keramikkörper verbunden ist. Die weitere Metallschicht ist vorzugsweise mit der der Hauptbegrenzungsfläche der Keramik abgewandten (und vorzugsweise zu dieser parallel verlaufenden) Begrenzungsfläche flächig verbunden. Die weitere (zweite) Metallschicht kann wie die (erste) Metallschicht beschaffen sein oder in ihrer Beschaffenheit von der (ersten) Metallschicht abweichen. Zur Beschaffenheit der weiteren (zweiten) Metallschicht wird auf die vorstehenden Erläuterungen zur (ersten) Metallschicht Bezug genommen.

Das erfindungsgemäße Metall-Keramik-Substrat kann insbesondere für Anwendungen in der Elektronik, vor allem für den Bereich der Leistungselektronik, eingesetzt werden.

Die Erfindung stellt daher auch ein elektronisches Bauteil bereit, das das erfindungsgemäße Metall-Keramik-Substrat umfasst.

Gemäß einer bevorzugten Ausführungsform umfasst das elektronische Bauteil das erfindungsgemäße Metall-Keramik-Substrat und wenigstens ein Halbleiterbauelement. Das wenigstens eine Halbleiterbauelement ist vorzugsweise flächig mit der (ersten) Metallschicht verbunden.

Gemäß einer weiteren bevorzugten Ausführungsform umfasst das Metall-Keramik-Substrat des elektronischen Bauteils eine weitere (zweite) Metallschicht. Die weitere (zweite) Metallschicht ist vorzugsweise flächig mit dem Keramikkörper verbunden. Dabei ist die weitere Metallschicht vorzugsweise mit der der Hauptbegrenzungsfläche des Keramikkörpers abgewandten (und vorzugsweise zu dieser parallel verlaufenden) Begrenzungsfläche des Keramikkörpers flächig verbunden.

Gemäß einer weiteren bevorzugten Ausführungsform umfasst das elektronische Bauteil einen Kühlkörper. Dieser Kühlkörper ist vorzugsweise mit der weiteren (zweiten) Metallschicht des Metall-Keramik-Substrats flächig verbunden. Alternativ kann die weitere (zweite) Metallschicht des Metall-Keramik-Substrats als Kühlkörper ausgebildet sein.

Gemäß einer weiteren bevorzugten Ausführungsform umfasst das elektronische Bauteil ein Metall-Keramik-Substrat, das eine (erste) Metallschicht und eine weitere (zweite) Metallschicht aufweist (wobei die weitere Metallschicht vorzugsweise mit der der Hauptbegrenzungsfläche des Keramikkörpers abgewandten Begrenzungsfläche flächig verbunden ist), ein Kühlkörper und wenigstens ein Halbleiterbauelement, wobei das wenigstens eine Halbleiterbauelement mit der ersten Metallschicht des Metall-Keramik-Substrats und der Kühlkörper mit der weiteren (zweiten) Metallschicht des Metall-Keramik-Substrats flächig verbunden sind.

Das erfindungsgemäße Metall-Keramik-Substrat kann durch unterschiedliche Herstellverfahren erhalten werden.

Die Erfindung stellt auch ein Verfahren zur Herstellung eines erfindungsgemäßen Metall-Keramik-Substrats bereit.

Das Verfahren zur Herstellung des Metall-Keramik-Substrats umfasst die Schritte:
a) Bereitstellung eines Metall-Keramik-Substrats aufweisend
   a1) einen Keramikkörper und
   a2) eine mit dem Keramikkörper flächig verbundene Metallschicht, und
b) Erzeugung wenigstens einer Aussparung in der Metallschicht, wobei eine Oberfläche des Keramikkörpers durch die Aussparung freigelegt ist, und die durch die Aussparung freigelegte Oberfläche des Keramikkörpers einen Gehalt von 0,5 - 15 Gewichtsprozent eines Aktivmetall aufweist.

In Schritt a) wird zunächst ein Metall-Keramik-Substrat bereitgestellt.

Dieses Metall-Keramik-Substrat weist einen Keramikkörper und eine mit dem Keramikkörper flächig verbundene Metallschicht auf. Bei dem Metall-Keramik-Substrat kann es sich um ein fachübliches Metall-Keramik-Substrat handeln. Der Keramikkörper und die Metallschicht können eine Zusammensetzung aufweisen, wie sie vorstehend in Bezug auf das Metall-Keramik-Substrat beschrieben ist. Die Metallschicht kann mit dem Keramikkörper vorzugsweise stoffschlüssig verbunden sein, wie dies ebenfalls vorstehend in Bezug auf das Metall-Keramik-Substrat beschrieben ist. Die stoffschlüssige Verbindung erfolgt vorzugsweise über ein Aktivlotverfahren, insbesondere ein AMB-Verfahren. Gemäß einer bevorzugten Ausführungsform ist das Metall-Keramik-Substrat daher ein in einem Aktivlotverfahren, insbesondere einem AMB-Verfahren, hergestelltes Metall-Keramik-Substrat.

In Schritt b) wird eine Aussparung in der Metallschicht erzeugt, wobei eine Oberfläche des Keramikkörpers durch die Aussparung freigelegt ist und die durch die Aussparung freigelegte Oberfläche des Keramikkörpers einen Gehalt von 0,5 - 15 Gewichtsprozent eines Aktivmetalls aufweist.

Die Aussparung in der Metallschicht wird vorzugsweise geschaffen, um einzelne Abschnitte der Metallschicht voneinander zu trennen und damit elektrisch zu isolieren. Die Aussparung legt daher eine Oberfläche des Keramikkörpers frei.

Die Aussparung kann grundsätzlich auf fachübliche Weise erzeugt werden. Vorzugsweise wird die Aussparung durch wenigstens ein abtragendes Verfahren erzeugt, das aus der Gruppe ausgewählt ist, die aus Ätzen, Eintragen von Strahlungsenergie und mechanischem Abtragen (zum Beispiel Nassstrahlen, Trockenstrahlen oder Fräsen) besteht. Besonders bevorzugt wird die Aussparung durch wenigstens ein abtragendes Verfahren erzeugt, das aus der Gruppe ausgewählt ist, die aus Ätzen und Eintragen von Strahlungsenergie besteht.

Gemäß einer bevorzugten Ausführungsform erfolgt die Erzeugung der Aussparung durch Ätzen.

Hierzu wird auf die Metallschicht vorzugsweise zunächst eine Ätzmaske aufgebracht. Die Ätzmaske dient dazu, die maskierten Bereiche der Metallschicht in einem Ätzschritt vor dem Ätzen zu schützen. Dies stellt sicher, dass nur solche Bereiche der Metallschicht des Metall-Keramik-Substrats für das Ätzen zugänglich sind, die unmaskiert und für die Schaffung der Aussparung vorgesehen sind. Folglich ist die Ätzmaske so beschaffen, dass im Ätzschritt kein Ätzen der maskierten Bereiche der Metallschicht erfolgt. Die Art der Ätzmaske ist nicht weiter eingeschränkt. Bei der Ätzmaske kann es sich beispielsweise um eine fachübliche Negativmaske oder Positivmaske handeln. Für die Erzeugung der Ätzmaske können fachübliche Ätzresists zum Einsatz kommen. Diese Ätzresists enthalten vorzugsweise ein härtbares Polymer (zum Beispiel ein lichthärtbares Polymer) und können zum Beispiel als Folie (zum Beispiel als Trockenfilm) oder als Flüssigkeit (zum Beispiel durch Drucken oder Sprühen) auf die Metallschicht aufgebracht werden. Nach dem Aufbringen können die Ätzresists auf eine geeignete Weise behandelt (zum Beispiel durch Lichteinstrahlung gehärtet) werden, um die Ätzmaske zu erhalten. Gemäß einer möglichen Ausführungsform wird auf die Metallschicht des Metall-Keramik-Substrats eine photosensitive Folie aufgebracht, die anschließend an den zu maskierenden Bereichen belichtet wird, um die Ätzmaske zu erhalten. Die unbelichteten Bereiche der photosensitiven Folie können im Anschluss auf fachübliche Weise entfernt werden (zum Beispiel unter Einsatz einer Natriumcarbonatlösung).

Das Ätzen erfolgt vorzugsweise in einem Schritt b1 (Ätzen) und einem Schritt b2 (Ätzen).

In Schritt b1 (Ätzen) erfolgt vorzugsweise das Ätzen von unmaskierten Bereichen der Metallschicht unter Erhalt einer Aussparung. Das Ätzen erfolgt vorzugsweise auf fachübliche Weise. Vorzugsweise erfolgt das Ätzen daher mit einer fachüblichen Ätzlösung. Gemäß einer bevorzugten Ausführungsform ist die Ätzlösung aus der Gruppe ausgewählt, die aus FeCl₃-Ätzlösungen und CuCl₂-Ätzlösungen besteht.

Nach dem Ätzen in Schritt b1 (Ätzen) kann auf dem Keramikkörper noch eine Aktivmetall enthaltende Reaktionsschicht vorhanden sein, wenn zum Beispiel das Metall-Keramik-Substrat gemäß einem AMB-Verfahren unter Verwendung eines Aktivlots hergestellt wurde. In diesem Fall wird durch herkömmliche Ätzlösungen die Metallschicht üblicherweise bis zur Reaktionsschicht abtragen, so dass die darunter liegende Oberfläche des Keramikkörpers noch nicht freigelegt ist und die ansonsten getrennten Bereiche der Metallschicht weiterhin über die zurückbleibende Reaktionsschicht elektrisch miteinander verbunden sind.

Daher erfolgt in einem Schritt b2 (Ätzen) vorzugsweise ein teilweises Abtragen der zurückbleibenden und in Schritt b1 (Ätzen) freigelegten Reaktionsschicht durch ein weiteres Ätzen.

Das weitere Ätzen erfolgt vorzugsweise unter Verwendung einer weiteren (zweiten) Ätzlösung. Die weitere Ätzlösung kann aus der Gruppe ausgewählt sein, die aus Ätzlösungen enthaltend Wasserstoffperoxid und aus Ätzlösungen enthaltend Ammoniumperoxodisulfat besteht. Zum Beispiel kann die weitere Ätzlösung eine Ätzlösung sein, die Ammoniumfluorid und Fluorborsäure (zum Beispiel HBF₄) sowie Wasserstoffperoxid und/oder Ammoniumperoxodisulfat enthält.

Nach Schritt b2 (Ätzen) erfolgt vorzugsweise das Entfernen der Ätzmaske. Die Ätzmaske kann auf eine fachübliche Weise entfernt werden. Hierzu kann das Metall-Keramik-Substrat beispielsweise mit einer alkalischen Lösung (zum Beispiel einer 2,5%igen Natriumhydroxidlösung) behandelt werden.

Gemäß einer weiteren bevorzugten Ausführungsform erfolgt die Erzeugung der Aussparung durch eine Kombination aus Ätzen und dem Eintragen von Strahlungsenergie.

In Schritt b1 (Ätzen) erfolgt vorzugsweise das Ätzen von unmaskierten Bereichen der Metallschicht unter Erhalt einer Aussparung wie vorstehend dargestellt.

In Schritt b2 (Strahlung) erfolgt vorzugsweise ein teilweises Abtragen der zurückbleibenden und in Schritt b1 (Ätzen) freigelegten Reaktionsschicht durch das Eintragen von Strahlungsenergie.

Das Eintragen von Strahlungsenergie erfolgt vorzugsweise durch Verwendung eines Ultrakurzpulslasers (zum Beispiel eines IR-Picosekunden- oder Femtosekundenlasers). Ein Ultrakurzpulslaser ist ein Laser, der Laserpulse mit einer Pulsdauer im Bereich von Pikosekunden ("Pikosekundenlaser") oder Femtosekunden ("Femtosekundenlaser") emittieren kann. Der gepulste Laserstrahl des Ultrakurzpulslasers weist beispielsweise Laserpulse mit einer Pulsdauer im Bereich von Pikosekunden ("Pikosekundenlaser") oder Femtosekunden ("Femtosekundenlaser") auf. Beispielsweise beträgt die Pulsdauer 1 fs bis 100 ps (z.B. 1 bis 100 ps oder 1 bis < 1000 fs).

Das Entfernen der Ätzmaske kann in diesem Fall nach oder bereits vor Schritt b2 (Strahlung) auf eine herkömmliche, zum Beispiel wie vorstehend beschriebene Weise erfolgen.

Gemäß einer weiteren bevorzugten Ausführungsform erfolgt die Erzeugung der Aussparung durch das Eintragen von Strahlungsenergie.

Dabei erfolgt in einem Schritt b (Strahlung) vorzugsweise die Erzeugung einer Aussparung durch teilweises Abtragen der Metallschicht einschließlich der Aktivmetall enthaltenden Reaktionsschicht.

Das Eintragen von Strahlungsenergie erfolgt vorzugsweise durch Verwendung eines Ultrakurzpulslasers (zum Beispiel eines IR-Picosekunden- oder Femtosekundenlasers) wie vorstehend beschrieben. Sofern die Erzeugung der Aussparung durch das Eintragen von Strahlungsenergie erfolgt, kann auf das Aufbringen einer Ätzmaske verzichtet werden.

In Schritt b) werden die Parameter für das Schaffen eine Aussparung in der Metallschicht vorzugsweise direkt so gewählt, dass eine Oberfläche des Keramikkörpers durch die Aussparung freigelegt ist und die durch die Aussparung freigelegte Oberfläche des Keramikkörpers einen Gehalt von 0,5 - 15 Gewichtsprozent eines Aktivmetall aufweist. Ebenso werden die Parameter für das Schaffen eine Aussparung in der Metallschicht vorzugsweise direkt so gewählt, dass die durch die wenigstens eine Aussparung freigelegte Oberfläche des Keramikkörpers Aktivmetallinseln aufweist, und die Aktivmetallinseln eine durchschnittliche Fläche im Bereich von 5 - 65 µm² aufweisen und/oder die Aktivmetallinseln durchschnittlich wenigstens 2 µm voneinander beabstandet sind.

Sofern die Aussparung in der Metallschicht durch Ätzen erzeugt wird, ist in Schritt b2 (Ätzen) insbesondere die Konzentration der weiteren (zweiten) Ätzlösung, der Einwirkzeit der weiteren (zweiten) Ätzlösung auf das in Schritt b1 (Ätzen) bereitgestellte Metall-Keramik-Substrat und die Behandlungstemperatur und Behandlungszeit bestimmend für den Gehalt der durch die Aussparung freigelegten Oberfläche des Keramikkörpers an Aktivmetall sowie die Gegenwart und Beschaffenheit der Aktivmetallinseln. Die für die Einstellung des erfindungsgemäßen Wertes erforderlichen Parameter können beispielsweise durch eine einfache Versuchsreihe ermittelt werden, in der die Konzentration der weiteren (zweiten) Ätzlösung, die Einwirkzeit der weiteren (zweiten) Ätzlösung und die Behandlungstemperatur und Behandlungszeit variiert werden.

Sofern die Aussparung in der Metallschicht durch das Eintragen von Strahlungsenergie erzeugt wird, ist in Schritt b (Strahlung) oder in Schritt b2 (Strahlung) insbesondere die Gesamtfluenz des vorzugsweise verwendeten Ultrakurzpulslasers bestimmend für den Gehalt der durch die Aussparung freigelegten Oberfläche des Keramikkörpers an Aktivmetall sowie die Gegenwart und Beschaffenheit der Aktivmetallinseln. Die für die Einstellung des erfindungsgemäßen Wertes erforderlichen Laserparameter können beispielsweise durch eine einfache Versuchsreihe ermittelt werden, in der die Laserfluenz variiert wird.

Mit dem hierin beschriebenen Verfahren lässt sich ein Metall-Keramik-Substrat erhalten, das eine hohe Teilentladungsfestigkeit aufweist.

Die Erfindung wird nachstehend in Bezug auf eine Figur beschrieben, die jedoch nicht beschränkend verstanden werden soll.

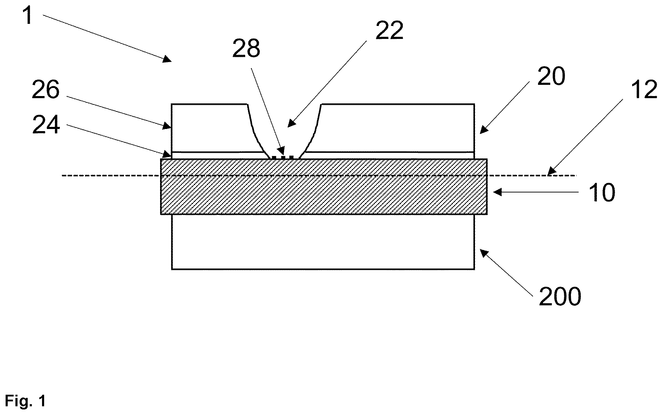

Figur 1 zeigt die Seitenansicht eines erfindungsgemäßen Metall-Keramik-Substrats (nicht maßstabsgetreu).

Das in Figur 1 gezeigte Metall-Keramik-Substrat 1 umfasst einen Keramikkörper 10 (mit einer Haupterstreckungsebene 12) und eine Metallschicht 20. Die Metallschicht 20 ist flächig mit der Hauptbegrenzungsfläche des Keramikkörpers 10 verbunden. In der Ausführungsform gemäß Figur 1 weist das Metall-Keramik-Substrat 1 ferner eine weitere Metallschicht 200 auf, die flächig mit dem Keramikkörper 10 verbunden ist. Die Metallschicht 20 umfasst eine Reaktionsschicht 24 und eine übrige Metallschicht 26. Die Reaktionsschicht 24 umfasst vorzugsweise ein Aktivmetall und steht mit dem Keramikkörper 10 in Kontakt. Ferner steht die Reaktionsschicht 24 mit der übrigen Metallschicht 26 in Kontakt. Die Metallschicht 20 weist eine Aussparung 22 auf, die die Oberfläche des Keramikkörpers 10 freilegt. Die durch die Aussparung 22 freigelegte Oberfläche des Keramikkörpers 10 weist einen Gehalt von 0,5 - 15 Gewichtsprozent eines Aktivmetall aufweist auf. Das Aktivmetall liegt vorzugsweise in Form von Aktivmetallinseln 28 vor. Die Aktivmetallinseln 28 weisen eine durchschnittliche Fläche im Bereich von 5 - 65 µm² auf und sind durchschnittlich wenigstens 2 µm voneinander beabstandet.

### Testmethoden

*1. Bestimmung des Gehalts von Aktivmetall an der durch die Aussparung freigelegten Oberfläche des Keramikkörpers*

Der Gehalt von Aktivmetall an der durch die Aussparung freigelegten Oberfläche des Keramikkörpers wird vorzugsweise mittels Rasterelektronenmikroskopie - energiedispersiver Röntgenspektroskopie (SEM-EDX) bestimmt.

Bei SEM-EDX wird ein fokussierter Primärelektronenstrahl punktweise über die Probenoberfläche geführt (gerastert). Die rückgestreuten Elektronen und die Sekundärelektronen werden von den Detektoren in der SEM-Kammer erfasst, wobei die Elektronenzahl pro Bildpunkt ein mikroskopisches Abbild der Probenoberfläche in Graustufen ergibt. Zusätzlich regt der Primärelektronenstrahl die Probe zur Emission von charakteristischer Röntgenstrahlung an, wobei die Elemente in der Probe und deren Gewichtsanteil durch die Analyse des Energiespektrums mit einem EDX-Detektor bestimmt werden kann.

Für die Untersuchung wird vorzugsweise ein Rasterelektronenmikroskop (zum Beispiel Gemini Ultra 55, ZEISS Ltd) mit einem Silizium Drift EDX Detektor (zum Beispiel Ultimax 100, Oxford Instruments) und eine Analysesoftware (zum Beispiel AZtec, Oxford Instruments) verwendet. Zur Vorbereitung der Untersuchung wird die Probenoberfläche zunächst mit einer sehr dünnen (wenige nm-dicken) Kohlenstoffschicht beschichtet (zum Beispiel mit dem SCD 005 Sputter Coater mit CEA 035 Carbon Evaporation Supply, BalTec AG). Danach wird die Probe in der Probenkammer positioniert und die Kammer unter Vakuum gesetzt. Anschließend erfolgt die Untersuchung mittels SEM-EDX. Hierfür werden vorzugsweise folgende Einstellungen verwendet: Vergrößerung: 100fach, 500fach und 1000fach; Beschleunigungsspannung = 15 kV. Für jeden auf der Probenfläche vermessenen Punkt wird ein separates EDX-Spektrum aufgenommen. Alle aufgenommenen EDX-Spektren werden durch die Analysesoftware prozessiert, um eine quantitative chemische Zusammensetzung für jeden Punkt zu bestimmen. Damit lässt sich der durchschnittliche Gehalt an Elementen an der Probenoberfläche (zum Beispiel des Aktivmetalls) quantitativ bestimmen. Der Gehalt der Elemente wird sowohl in Atomprozent als auch in Gewichtsprozent bestimmt, wobei die Gesamtmenge 100% entspricht. Die Analyse wird vorzugsweise bei 100-facher Vergrößerung durchgeführt.

### 2. Bestimmung von Fläche und Abstand der Aktivmetallinseln

Die Aktivmetallinseln werden vorzugsweise mittels Rasterelektronenmikroskopie - energiedispersiver Röntgenspektroskopie (SEM-EDX) bestimmt, wie dies vorstehend (unter "Bestimmung des Gehalts von Aktivmetall an der durch die Aussparung freigelegten Oberfläche des Keramikkörpers") beschrieben ist. In einer mittels SEM-EDX erhaltenen Aufnahme werden die Aktivmetallinseln dabei als abgrenzbare Bereiche mit einer Akkumulation von Aktivmetall identifiziert. Dabei wird aus den mittels SEM-EDX erhaltenen Daten durch die Analysesoftware eine elektronenmikroskopische Aufnahme zusammengesetzt (EDX-Mapping). Mit dem EDX-Mapping wird die räumliche Verteilung von ausgewählten Elementen (zum Beispiel Aktivmetallinseln) auf der Probenoberfläche dargestellt. Die Flächen sowie Abstände der Aktivmetallinseln werden vorzugsweise mittels der Software ImageJ (1.53c) ausgewertet. Hierzu werden die Aktivmetallinseln vorzugsweise mit je einer Konturlinie umfahren. Der Flächeninhalt, den die jeweiligen von der Konturlinie umschlossenen Bereiche aufweisen, wird sodann von der Software ausgegeben. Anschließend werden die jeweils kürzesten Abstände zweier benachbarter Aktivmetallinseln über das Einzeichnen einer Geraden, die beide Konturlinien miteinander verbindet, bestimmt. Die Länge der jeweiligen Geraden wird ebenfalls von der Software ausgegeben.

Insgesamt werden vorzugsweise wenigstens drei SEM-EDX-Messungen je Probe ausgewertet. Dabei werden vorzugsweise alle in der Aufnahme erkennbaren Aktivmetallinseln wie vorstehend beschrieben ausgewertet. Die durchschnittliche Fläche der Aktivmetallinseln und der durchschnittliche Abstand der Aktivmetallinseln werden vorzugsweise als arithmetische Mittelwerte sämtlicher in den Aufnahmen erkennbarer Aktivmetallinseln angegeben.

### Ausführungsbeispiele

Die vorliegende Erfindung wird nachstehend durch Ausführungsbeispiele näher beschrieben, die jedoch nicht als einschränkend verstanden werden sollen.

### 1. Herstellung

Zur Herstellung von Metall-Keramik-Substraten der Beispiele 1 bis 5 und der Vergleichsbeispiele 1 und 2 wurden Kupfer-Keramik-Substrate verwendet, bei denen jeweils ein Keramikkörper aus einer Siliziumnitridkeramik mit der Abmessung 177,8 x 139 x 0,32 mm beidseitig mit jeweils einer Kupferschicht mit der Abmessung 170 x 132 x 0.3 mm über ein AMB (Active Metal Brazing) -Verfahren, verbunden war. Die Kupfer-Keramik-Substrate wiesen jeweils eine titanhaltige Reaktionsschicht auf, die auf die Verwendung eines titanhaltigen Aktivlotes bei der Herstellung der Kupfer-Keramik-Substrate zurückzuführen war.

Diese Kupfer-Keramik-Substrate wurden nach der Herstellung zunächst gereinigt. Sodann wurde auf beide Kupferschichten der Kupfer-Keramik-Substrate mittels eines Hot Roll Laminator eine photosensitive Folie aufgebracht. Die photosensitive Folie wurde jeweils mit 30 mJ/cm² an den zu maskierenden Bereichen belichtet, um das in der photosensitiven Folie enthaltene Polymer zu härten und eine Ätzmaske zu erhalten. Im Anschluss wurden die unbelichteten Stellen der photosensitiven Folie nasschemisch unter Verwendung einer Natriumcarbonatlösung (Konzentration = 10 g/l) entfernt. Nach dem Aufbringen der Ätzmaske wurden die Kupfer-Keramik-Substrate durch Spülen gereinigt. Anschließend wurden die unmaskierten Bereiche der Kupferschichten der Kupfer-Keramik-Substrate nasschemisch geätzt. Hierzu wurden die Kupfer-Keramik-Substrate in einer Ätzanlage mit einer salzsauren Kupferchloridlösung (Kupferionengehalt = 160 g/l) enthaltend Wasserstoffperoxid besprüht. Das Ätzen erfolgte bei einer Temperatur von 50°C und bei einem Sprühdruck von 2,8 bar. Durch das Ätzen wurde Material aus den unmaskierten Bereichen der Kupferschichten der Kupfer-Keramik-Substrate abgetragen. Die Kupfer-Keramik-Substrate wurden danach gespült.

Anschließend wurden unmaskierte Bereiche der in den Kupfer-Keramik-Substraten enthaltenen titanhaltigen Reaktionsschicht ebenfalls nasschemisch geätzt. Hierzu wurden die Kupfer-Keramik-Substrate wiederum in einer Ätzanlage mit einer Ätzlösung besprüht, die Ammoniumfluorid, Fluorborsäure und Wasserstoffperoxid enthielt. Dabei wurde bei den einzelnen Kupfer-Keramik-Substraten die Kontaktzeit mit der Ätzlösung variiert, um die in Tabelle 1 gemessenen Rückstande an Titan zu erhalten. Anschließend wurden die Kupfer-Keramik-Substrate gespült und getrocknet. Danach wurde die Ätzmaske in einer Strippanlage mit einer 2,5%igen Natriumhydroxidlösung entfernt.

Dies so hergestellten Kupfer-Keramik-Substrate wiesen auf der Vorderseite des Keramikkörpers je einen großen Kontaktbereich aus Kupfer mit einer Fläche von 200 mm² und je einen kleinen Kontaktbereich aus Kupfer mit einer Fläche von 20 mm² auf, wobei die Kontaktbereiche aus Kupfer durch eine 1,2 mm breite Aussparung voneinander getrennt waren. Der Abstand zwischen den Kontaktbereichen aus Kupfer und den Außenkanten des Keramikkörpers betrug jeweils 0,8 mm (als umlaufender Rand). Die Rückseite des Keramikkörpers war jeweils vollflächig mit Kupfer beschichtet, wobei der Abstand zwischen der Kupferbeschichtung und den Außenkanten des Keramikkörpers jeweils 0,8 mm betrug (als umlaufender Rand).

### 2. Beschaffenheit der Kupfer-Keramik-Substrate

An den hergestellten Kupfer-Keramik-Substraten wurde der Gehalt an Titan and der durch die Aussparung freigelegten Oberfläche des Keramikkörpers mittels Rasterelektronenmikroskopie - energiedispersiver Röntgenspektroskopie (SEM-EDX) gemäß vorstehend beschriebenem Testverfahren bestimmt. Ebenfalls wurden die Titaninseln in einer elektronenmikroskopischen Aufnahme identifiziert und die Flächen sowie Abstände der Titaninseln gemäß vorstehend beschriebenem Testverfahren untersucht. Die Ergebnisse sind in Tabelle 1 dargestellt.

**Tabelle 1: Titangehalt, durchschnittliche Fläche der Titaninseln und durchschnittlicher Abstand der Titaninseln in den Aussparungen der in den Ausführungsbeispielen hergestellten Kupfer-Keramik-Substrate.**

| | Titangehalt in Aussparung (in Gewichtsprozent) | Durchschnittliche Fläche der Titaninseln (in µm²) | Durchschnittlicher Abstand der Titaninseln (in µm) |
|---|---|---|---|
| Beispiel 1 | 0,8 | 12 | 13,5 |
| Beispiel 2 | 1,8 | 18 | 11,5 |
| Beispiel 3 | 5,1 | 25 | 8,6 |
| Beispiel 4 | 10,7 | 38 | 7,2 |
| Beispiel 5 | 14,0 | 60 | 5,6 |
| Vergleichsbeispiel 1 | <0,5 | < 5 | > 20 |
| Vergleichsbeispiel 2 | 15,9 | 66 | 1,4 |

### 3. Auswertung

Die in den Beispielen 1 bis 5 und den Vergleichsbeispielen 1 und 2 erhaltenen Kupfer-Keramik-Substrate wurden auf ihre Teilentladungsfestigkeit (Kontaktbereich/Kontaktbereich und Top/Bottom) hin untersucht.

Hierzu wurden die Kupfer-Keramik-Substrate in isolierende Rahmen eingespannt, die die jeweiligen Ober- und Unterseiten randseitig vollständig umschlossen und somit die Ober- von der Unterseiten der Kupfer-Keramik-Substrate isolierten. Eine mittige Aussparung im isolierenden Rahmen ermöglichte die Kontaktierung der einzelnen Kontaktbereiche auf der Ober- und Unterseite der Kupfer-Keramik-Substrate mittels Federkontakten. Anschließend wurden die derart kontaktierten Kupfer-Keramik-Substrate in einen Kunststoffbehälter, der mit einer isolierenden Flüssigkeit (Galden HS 240) befüllt war, so eingelegt, dass die einzelnen Kontaktbereiche vollständig mit der isolierenden Flüssigkeit bedeckt waren. Die aus der isolierenden Flüssigkeit herausragenden Federkontakte wurden an das Mess- und Analysesystems MPD 600 (OMICRON Electronics) angeschlossen. Die Messung der Teilentladung erfolgte in Anlehnung an die Norm IEC 61287 mit einer abweichenden Betriebsspannung von 3,6 kV (50 Hz) (anstelle von 2,4 kV). (Die Wechselspannung wurde innerhalb von 10 s auf 3,6 kV hochgeregelt und für 60 s angelegt. Die angegebenen Werte der Teilentladung wurden in den letzten 10 s durch Bildung des Mittelwertes ermittelt.)

Für die Bestimmung der Teilentladung zwischen Ober- und Unterseite der Kupfer-Keramik-Substrate (Top/Bottom) wurde an alle Kontaktbereiche der Vorderseite die Betriebsspannung angelegt, während die Rückseitenmetallisierung auf GND-Potential gelegt wurde.

Für die Bestimmung der Teilentladung zwischen den Kontaktbereich aus Kupfer (Kontaktbereich/Kontaktbereich) wurde an den großen Kontaktbereich aus Kupfer die Betriebsspannung angelegt, während der kleine Kontaktbereich aus Kupfer zusammen mit der Rückseitenmetallisierung auf GND-Potential gelegt wurde, um Aufladungseffekt der Rückseitenmetallisierung zu verhindern.

Die Ergebnisse sind in Tabelle 2 dargestellt.

**Tabelle 2: Teilentladungsfestigkeit der in den Ausführungsbeispielen hergestellten Kupfer-Keramik-Substrate.**

| Beispiele | Teilentladungsfestigkeit (in pC) | |
|---|---|---|
| | Kontaktbereich/Kontaktbereich | Top/Bottom |
| Beispiel 1 | 0,06 | 0,07 |
| Beispiel 2 | 0,07 | 0,07 |
| Beispiel 3 | 0,08 | 0,07 |
| Beispiel 4 | 0,08 | 0,09 |
| Beispiel 5 | 0,09 | 0,09 |
| Vergleichsbeispiel 1 | 0,12 | 0,11 |
| Vergleichsbeispiel 2 | Spannungsdurchschlag | Spannungsdurchschlag |

Die Ergebnisse zeigen, dass die erfindungsgemäßen Kupfer-Keramik-Substrate gemäß den Beispielen 1 bis 5 den Kupfer-Keramik-Substraten der Vergleichsbeispiele 1 und 2 im Hinblick auf die Teilentladungsfestigkeit überlegen sind.

### Bezugszeichenliste:

- 1: Metall-Keramik-Substrat
- 10: Keramikkörper
- 12: Haupterstreckungsebene des Keramikkörpers
- 20: Metallschicht
- 22: Aussparung
- 24: Reaktionsschicht
- 26: Übrige Metallschicht
- 28: Aktivmetallinseln
- 200: Weitere Metallschicht

## Patentansprüche

1. Metall-Keramik-Substrat enthaltend
(i) einen Keramikkörper,
(ii) eine Metallschicht, die mit dem Keramikkörper flächig verbunden ist, wobei die Metallschicht wenigstens eine Aussparung aufweist und eine Oberfläche des Keramikkörpers durch die Aussparung freigelegt ist,
**dadurch gekennzeichnet, dass** die durch die Aussparung freigelegte Oberfläche des Keramikkörpers einen Gehalt von 0,5 - 15 Gewichtsprozent eines Aktivmetall aufweist.

2. Metall-Keramik-Substrat nach Anspruch 1, **dadurch gekennzeichnet, dass** die durch die wenigstens eine Aussparung freigelegte Oberfläche des Keramikkörpers Aktivmetallinseln aufweist, und die Aktivmetallinseln wenigstens eines der folgenden Merkmale erfüllen:
(A) die Aktivmetallinseln weisen eine durchschnittliche Fläche im Bereich von 5 - 65 µm² auf; und
(B) die Aktivmetallinseln sind durchschnittlich wenigstens 2 µm voneinander beabstandet.

3. Metall-Keramik-Substrat nach Anspruch 1 oder 2, **dadurch gekennzeichnet, dass** die Keramik des Keramikkörpers aus der Gruppe ausgewählt ist, die aus Aluminiumnitridkeramiken, Siliziumnitridkeramiken und Aluminiumoxidkeramiken besteht.

4. Metall-Keramik-Substrat nach einem der vorangegangenen Ansprüche, **dadurch gekennzeichnet, dass** die Metallschicht Kupfer umfasst.

5. Metall-Keramik-Substrat nach einem der vorangegangenen Ansprüche, **dadurch gekennzeichnet, dass** das Aktivmetall aus der Gruppe ausgewählt ist, die aus Hafnium, Titan, Zirkonium, Niob, Vanadium, Tantal und Cer besteht.

6. Elektronisches Bauteil umfassend ein Metall-Keramik-Substrat nach einem der vorangegangenen Ansprüche.
